(19) Europäisches Patentamt
European Patent Office
Office européen des brevets

(11) **EP 4 671 791 A1**

(12) **EUROPEAN PATENT APPLICATION**
published in accordance with Art. 153(4) EPC

(43) Date of publication:
**31.12.2025 Bulletin 2026/01**

(21) Application number: **24781071.6**

(22) Date of filing: **12.03.2024**

(51) International Patent Classification (IPC):
**G01R 31/392** (2019.01)    **G01R 31/385** (2019.01)
**G01R 31/52** (2020.01)    **G01R 19/10** (2006.01)
**G01R 19/00** (2006.01)    **G01R 19/165** (2006.01)
**G01R 19/12** (2006.01)

(52) Cooperative Patent Classification (CPC):
**G01R 19/00; G01R 19/10; G01R 19/12;
G01R 19/165; G01R 31/385; G01R 31/392;
G01R 31/52**

(86) International application number:
**PCT/KR2024/003173**

(87) International publication number:
**WO 2024/205080 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **31.03.2023 KR 20230043045**

(71) Applicant: **LG ENERGY SOLUTION, LTD.
Seoul 07335 (KR)**

(72) Inventors:
• **JUNG, Jin Won
Daejeon 34122 (KR)**
• **KIM, Ki Hoon
Daejeon 34122 (KR)**
• **JANG, Jin Woo
Daejeon 34122 (KR)**

(74) Representative: **Plasseraud IP
104 Rue de Richelieu
CS92104
75080 Paris Cedex 02 (FR)**

(54) **BATTERY MANAGEMENT APPARATUS AND OPERATION METHOD THEREFOR**

(57) A battery management apparatus according to one embodiment disclosed in the present document may comprise: a data management unit for calculating the state of health (SOH) or open circuit voltage (OCV) of each of a plurality of batteries; and a controller which determines at least one noise battery on the basis of the SOH or OCV of each of the plurality of batteries, determines at least one abnormal battery on the basis of the SOH or OCV of each of the at least one noise battery and the service life of each of the at least one noise battery, and diagnoses at least one target battery on the basis of a deviation in the OCV between a plurality of target batteries excluding the at least one noise battery from the plurality of batteries.

200

| DATA MANAGEMENT UNIT 210 | CONTROLLER 220 |

FIG.2

**Description**

**[TECHNICAL FIELD]**

CROSS-REFERENCE TO RELATED APPLICATION

This application claims priority to and the benefit of Korean Patent Application No. 10-2023-0043045 filed in the Korean Intellectual Property Office on March 31, 2023, the entire content of which is incorporated herein by reference.

TECHNICAL FIELD

Embodiments disclosed herein relate to a battery management apparatus and an operating method thereof.

**[BACKGROUND ART]**

An electric vehicle is supplied with electricity from outside to charge a battery cell, and then a motor is driven by a voltage charged in the battery cell to obtain power. A battery cell undergoes internal deformation and denaturation through various charges/discharges in production and use phases, such that physical and chemical characteristics thereof change, causing an inner short-circuit. When the inner short-circuit occurs in the battery cell, an under-voltage defect may occur in which a voltage of the battery cell decreases to a predetermined level or less and a possibility of ignition increases, resulting in a direct problem in the battery cell. Thus, a technique for determining whether the inner short-circuit occurs in the battery cell is required.

In a battery system in which a plurality of battery cells are coupled, a conventional battery management apparatus diagnoses an inner short-circuit by determining a relative voltage deviation according to a coupling order of the battery cells without considering a difference in degree of degradation (state of health (SOH)) of each battery cell. Such a method has a limitation of failing to detect a voltage fluctuation of a battery cell occurring due to an actual inner short-circuit because a capacity deviation corresponding to accumulation of use and natural degradation of a battery cell is not considered.

**[DISCLOSURE]**

**[TECHNICAL PROBLEM]**

Embodiments disclosed herein aim to provide a battery management apparatus and an operating method thereof in which an abnormal battery cell may be accurately diagnosed by reflecting a voltage deviation corresponding to a difference in degradation degree between battery cells.

Technical problems of the embodiments disclosed herein are not limited to the above-described technical problems, and other unmentioned technical problems would be clearly understood by one of ordinary skill in the art from the following description.

**[TECHNICAL SOLUTION]**

A battery management apparatus according to an embodiment disclosed herein includes a data management unit configured to calculate a degradation degree (a state of health (SOH)) or an open circuit voltage (OCV) of each of a plurality of batteries and a controller configured to determine at least one noise battery based on the SOH or the OCV of each of the plurality of batteries, determine at least one abnormal battery based on an SOH or an OCV of each of the at least one noise battery and a service life of each of the at least one noise battery, and diagnose at least one target battery based on a deviation of OCVs between a plurality of target batteries except for the at least one noise battery, among the plurality of batteries.

According to an embodiment, the controller may be further configured to determine, as the at least one noise battery, a battery having an SOH or an OCV falling out of a first threshold range, among the plurality of batteries.

According to an embodiment, the controller may be further configured to determine, as the at least one abnormal battery, a noise battery having a service life corresponding to a middle of life (MOL) and an SOH or an OCV falling out of a second threshold range, among the at least one noise battery.

According to an embodiment, the controller may be further configured to set the first threshold range by applying a value obtained by multiplying a standard deviation of the SOHs of the plurality of batteries and a first weight to a mean of SOHs of the plurality of batteries.

According to an embodiment, the controller may be further configured to set the second threshold range by applying a value obtained by multiplying the standard deviation of the SOHs of the plurality of batteries and a second weight to the mean of the SOHs of the plurality of batteries.

According to an embodiment, the controller may be further configured to calculate a first value which is a deviation of a difference of an OCV of each of the plurality of batteries relative to a difference of a mean of OCVs of the plurality of batteries and set the first threshold range by applying a value obtained by multiplying a standard deviation of the first values of the plurality of batteries and the first weight to a mean of first values of the plurality of batteries.

According to an embodiment, the controller may be further configured to set the second threshold range by applying a value obtained by multiplying the standard deviation of the first values of the plurality of batteries and a second weight to the mean of the first values of the plurality of batteries.

According to an embodiment, the controller may be further configured to calculate a deviation of an OCV of each of a plurality of target batteries relative to a mean of OCVs of the plurality of target batteries and calculate a difference of the deviation of the OCV of each of the plurality of target batteries.

According to an embodiment, the controller may be further configured to calculate a pattern of the difference of the deviation of the OCV of each of the plurality of target batteries by calculating the difference of the deviation of the OCV of each of the plurality of target batteries every specific periods, and diagnose at least one target battery by comparing the pattern of the difference of the deviation of the OCV of each of the plurality of target batteries with a plurality of diagnosis patterns.

According to an embodiment, the controller may be further configured to diagnose at least one target battery among the plurality of target batteries when a pattern of a difference of a deviation of an OCV of the at least one target battery corresponds to any one of the plurality of diagnosis patterns.

An operating method of a battery management apparatus according to an embodiment disclosed herein includes calculating a degradation degree (a state of health (SOH)) or an open circuit voltage (OCV) of each of a plurality of batteries, determining at least one noise battery based on the SOH or the OCV of each of the plurality of batteries, determining at least one abnormal battery based on an SOH or an OCV of each of the at least one noise battery and a service life of each of the at least one noise battery, and diagnosing at least one target battery based on a deviation of OCVs between a plurality of target batteries except for the at least one noise battery, among the plurality of batteries.

According to an embodiment, the determining of the at least one noise battery based on the SOH or the OCV of each of the plurality of batteries may include determining, as the at least one noise battery, a battery having an SOH or an OCV falling out of a first threshold range, among the plurality of batteries.

According to an embodiment, the determining of the at least one abnormal battery based on the SOH or the OCV of each of the at least one noise battery and the service life of each of the at least one noise battery may include determining, as the at least one abnormal battery, a noise battery having a service life corresponding to a middle of life (MOL) and an SOH or an OCV falling out of a second threshold range, among the at least one noise battery.

According to an embodiment, the determining of the at least one noise battery based on the SOH or the OCV of each of the plurality of batteries may include setting the first threshold range by applying a value obtained by multiplying a standard deviation of the SOHs of the plurality of batteries and a first weight to a mean of SOHs of the plurality of batteries.

According to an embodiment, the determining of the at least one abnormal battery based on the SOH or the OCV of each of the at least one noise battery and the service life of each of the at least one noise battery may include setting the second threshold range by applying a value obtained by multiplying a standard deviation of the SOHs of the plurality of batteries and a second weight to a mean of SOHs of the plurality of batteries.

According to an embodiment, the determining of the at least one noise battery based on the SOH or the OCV of each of the plurality of batteries may include calculating a first value which is a deviation of a difference of an OCV of each of the plurality of batteries relative to a difference of a mean of OCVs of the plurality of batteries and setting the first threshold range by applying a value obtained by multiplying a standard deviation of the first values of the plurality of batteries and the first weight to a mean of first values of the plurality of batteries.

According to an embodiment, the determining of the at least one abnormal battery based on the SOH or the OCV of each of the at least one noise battery and the service life of each of the at least one noise battery may include setting the second threshold range by applying a value obtained by multiplying the standard deviation of the first values of the plurality of batteries and the second weight to the mean of first values of the plurality of batteries.

According to an embodiment, the diagnosing of the at least one target battery based on a deviation of OCVs between a plurality of target batteries except for the at least one noise battery, among the plurality of batteries, may include calculating a deviation of an OCV of each of a plurality of target batteries relative to a mean of OCVs of the plurality of target batteries and calculating a difference of the deviation of the OCV of each of the plurality of target batteries.

According to an embodiment, the diagnosing of the at least one target battery based on a deviation of OCVs between a plurality of target batteries except for the at least one noise battery, among the plurality of batteries, may include calculating a pattern of a difference of a deviation of an OCV of each of the plurality of target batteries by calculating the difference of the deviation of the OCV of each of the plurality of target batteries every specific periods and diagnosing at least one target battery by comparing the pattern of the difference of the deviation of the OCV of each of the plurality of target batteries with a plurality of diagnosis patterns.

According to an embodiment, the diagnosing of the at least one target battery based on a deviation of OCVs between a plurality of target batteries except for the at least one noise battery, among the plurality of batteries, may include diagnosing at least one target battery among the plurality of target batteries when a pattern of a difference of a deviation of an OCV of the at least one target battery corresponds to any one of the plurality of diagnosis patterns.

**[ADVANTAGEOUS EFFECTS]**

With the battery management apparatus and the operating method thereof according to an embodiment disclosed herein, an abnormal battery cell may be accurately diagnosed by reflecting a voltage deviation corresponding to a difference in degradation degree between battery cells.

**[DESCRIPTION OF DRAWINGS]**

FIG. 1 illustrates a battery pack according to an embodiment disclosed herein.

FIG. 2 is a block diagram illustrating a configuration of a battery management apparatus, according to an embodiment disclosed herein.

FIG. 3 is a graph showing a threshold range according to an embodiment disclosed herein.

FIG. 4 is a flowchart illustrating a method of identifying a target battery cell of a controller, according to an embodiment disclosed herein.

FIG. 5 is a flowchart illustrating a method of diagnosing a target battery cell of a controller, according to an embodiment disclosed herein.

FIG. 6 is a flowchart showing an operating method of a battery management apparatus, according to an embodiment disclosed herein.

FIG. 7 is a block diagram showing a hardware configuration of a computing system for performing an operating method of a battery management apparatus, according to an embodiment disclosed herein.

**[MODE FOR INVENTION]**

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

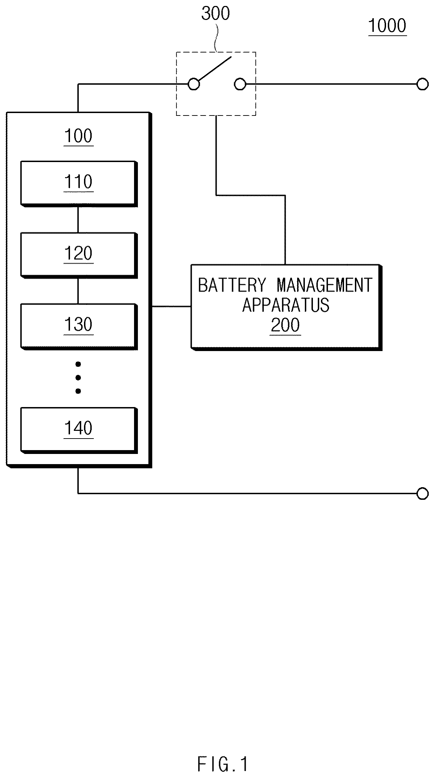

FIG. 1 illustrates a battery pack according to an embodiment disclosed herein.

Referring to FIG. 1, a battery pack 1000 according to an embodiment disclosed herein may include a battery module 100, a battery management apparatus 200, and a relay 300. According to various embodiments, the battery module 100 may be a battery cell, and in this case, the battery pack 1000 may have a cell-to-pack structure.

Meanwhile, although one battery module 100 is illustrated in FIG. 1, the battery module 100 may be configured in plural and the battery pack 1000 may have a stacked structure of a plurality of battery modules, according to an embodiment. The battery module 100 may include a plurality of battery cells 110, 120, 130, and 140. Although the plurality of battery cells are illustrated as four in FIG. 1, the present disclosure is not limited thereto, and the battery module 100 may include n battery cells (n is a natural number equal to or greater than 2).

The battery module 100 may supply power to a target device (not shown). To this end, the battery module 100 may be electrically connected to the target device. Herein, the target device may include an electrical, electronic, or mechanical device that operates by receiving power from the battery pack 1000 including the plurality of battery cells 110, 120, 130, and 140, and the target device may be, for example, an electric vehicle (EV) or an energy storage system (ESS), but is not limited thereto.

The plurality of battery cells 110, 120, 130, and 140, each of which is a basic unit of a battery available by charging and discharging electrical energy, may be a lithium ion (Li-ion) battery, an Li-ion polymer battery, a nickel-cadmium (Ni-Cd) battery, a nickel hydrogen (Ni-MH) battery, etc., and are not limited thereto. Meanwhile, although one battery module 100 is illustrated in FIG. 1, the battery module 100 may be configured in plural according to an embodiment.

The battery management apparatus (a battery management system (BMS)) 200 may manage and/or control a state and/or an operation of the battery module 100. For example, the battery management apparatus 200 may manage and/or control the states and/or operations of the plurality of battery cells 110, 120, 130, and 140 included in the battery module 100. The battery management apparatus 200 may manage charging and/or discharging of the battery module 100.

The battery management apparatus 200 may control an operation of the relay 300. For example, the battery management apparatus 200 may short-circuit the relay 300 to supply power to the target device. The battery management apparatus 200 may short-circuit the relay 300 when a charging device is connected to the battery pack 1000.

In addition, the battery management apparatus 200 may monitor a voltage, a current, a temperature, etc., of the battery module 100 and/or each of the plurality of battery cells 110, 120, 130, and 140 included in the battery module 100. A sensor or various measurement modules for monitoring performed by the battery management apparatus 200, which are not shown, may be additionally installed in the battery module 100, a charging/discharging path, any position of the battery module 100, etc. The battery management apparatus 200 may calculate a parameter indicating a state of the battery module 100, e.g., a state of charge (SOC), a state of health (SOH) etc., based on a measurement value such as monitored voltage, current, temperature, etc.

For the plurality of battery cells 110, 120, 130, and 140, as a period of use or the number of times of use increases, a capacity may decrease and internal resistance may increase, and as such, various factors of the battery may change. The battery management apparatus 200 may diagnose an abnormal phenomenon inside the plurality of battery cells 110, 120, 130, and 140 based on data of various factors changing with deterioration of the battery.

More specifically, the battery management apparatus 200 may determine internal abnormal voltages of the plurality of battery cells 110, 120, 130, and 140 based on data of various factors changing with deterioration of the plurality of battery cells 110, 120, 130, and 140 to determine whether an abnormal battery cell exists inside the plurality of battery banks 110, 120, 130, and 140.

For example, the battery management apparatus 200 may calculate deviations dV of open circuit voltages (OCVs) of the plurality of battery cells 110, 120, 130, and 140 through OCV data of the plurality of battery cells 110, 120, 130, and 140. The battery management apparatus 200 may diagnose whether an inner short-circuit of at least one battery cell among the plurality of battery cells 110, 120, 130, and 140 occurs by using a mean of the deviations dV of the OCVs of the plurality of battery cells 110, 120, 130, and 140 and the deviation of the OCV of each of the plurality of battery cells 110, 120, 130, and 140. A battery cell in which an inner short-circuit occurs may have a voltage deviation with a normal battery cell due to self-discharge over time.

The battery management apparatus 200 may determine a plurality of target battery cells except for a noise battery cell with suspected noise data by comparing a mean of the SOHs or the OCVs of the plurality of battery cells 110, 120, 130, and 140 included in the battery pack 1000 with an OCV or SOH of each of the plurality of battery cells 110, 120, 130, and 140. After determining a plurality of target battery cells, the battery management apparatus 200 may diagnose a battery cell having an inner short-circuit occurring by using a difference of the deviations dV of the OCVs of the plurality of target battery cells included in the battery pack 1000. The battery management apparatus 200 may also determine an abnormal battery cell suspected to be defective due to an abnormal voltage among noise battery cells.

The following operation of the battery management apparatus 200 may also be performed in the battery management apparatus 200 or various devices such as a server, a cloud, a charger, a charger/discharger, etc., connected to a vehicle having the battery management apparatus 200 mounted thereon.

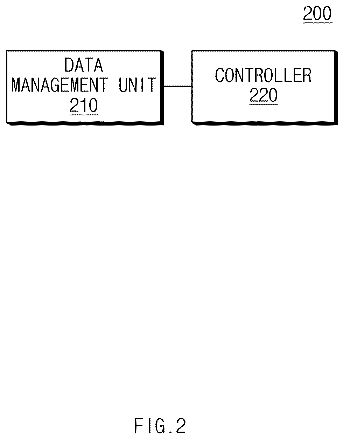

FIG. 2 is a block diagram illustrating a configuration of a battery management apparatus, according to an embodiment disclosed herein.

Hereinbelow, a configuration of the battery management apparatus 200 will be described in detail with reference to FIG. 2.

Referring to FIG. 2, the battery management apparatus 200 may include a data management unit 210 and a controller 220.

The data management unit 210 may calculate an SOH or OCV of each of the plurality of battery cells 110, 120, 130, and 140.

Herein, the OCV may mean a voltage measured when the current of the battery does not flow. That is, the OCV may be a voltage between both electrodes in a state where a fuel electrode (anode) and an air electrode (cathode) of the battery are not electrically connected to each other. According to the Ohm's law, as the battery's resistance increases infinitely, the current may approach '0', thereby accurately measuring a voltage of the battery. Thus, the data management unit 210 may measure the OCVs of the plurality of battery cells 110, 120, 130, and 140 for accurate electrochemical analysis of the plurality of battery cells 110, 120, 130, and 140.

The SOH is an index indicating a health state or life state of the battery in the current state with respect to an initial state of the battery. A moment at which the SOH reaches 0 % may be defined as an end of life (EOL). In addition, the end of life of the battery may be a moment at which the capacity of the battery reaches a guaranteed capacity or less. For example, the data management unit 210 may calculate the SOH of the plurality of battery cells 110, 120, 130, and 140 based on at least one factor of internal resistance, impedance, conductance, capacity, voltage, self-discharge current, charge performance, and the number of times of charge and discharge of the plurality of battery cells 110, 120, 130, and 140, which change with deterioration of the plurality of battery cells 110, 120, 130, and 140.

For example, the data management unit 210 may calculate an individual SOH, i.e., an SOHC of each battery cell by using the OCVs and current integrated value of the plurality of battery cells 110, 120, 130, and 140. Specifically, the battery management apparatus 200 may calculate before-charge $OCV_A$ and after-charge $OCV_B$ of the plurality of battery cells 110, 120, 130, and 140.

The data management unit 210 may calculate $SOC_A$ and $SOC_B$ by changing $OCV_A$ and $OCV_B$ into the amount of charge, i.e., SOCs, based on an OCV table. The battery management apparatus 200 may calculate individual SOHs of the plurality of battery cells 110, 120, 130, and 140, based on [Equation 1].

[Equation 1]

$$SOHC = \frac{I}{(SOC_B - SOC_A)/100 \times X} \times 100$$

Herein, ($SOC_B - SOC_A$) may mean an SOC deviation, I may mean an accumulated charging current, and X may mean a capacity of an existing battery cell. The data management unit 210 may calculate an individual SOH of each of the plurality of battery cells 110, 120, 130, and 140, based on [Equation 1].

The controller 220 may determine at least one noise battery cell among the plurality of battery cells 110, 120, 130, and 140, based on an SOHC or an OCV of each of the plurality of battery cells 110, 120, 130, and 140. After determining the at least one noise battery cell based on the SOHC or the OCV of each of the plurality of battery cells 110, 120, 130, and 140, the controller 220 may identify a plurality of target battery cells except for the at least one noise battery cell from among the plurality of battery cells 110, 120, 130, and 140. The controller 220 may diagnose at least one target battery cell based on deviations of OCVs between a plurality of target battery cells. The controller 220 may also determine an abnormal battery cell among the at least one noise battery cell based on an SOH or an OCV of each of the at least one noise battery cell and a service life of each of the at least one noise battery cell.

A detailed description will be made of an operation, performed by the controller 220, of determining a noise battery cell based on SOHs or OCVs of the plurality of battery cells 110, 120, 130, and 140. The controller 220 may set a threshold range for identifying a target battery cell among the plurality of battery cells 110, 120, 130, and 140 by using a mean and a standard deviation σ of the SOHs or the OCVs of the plurality of battery cells 110, 120, 130, and 140. Herein, the threshold range may be defined as a reference range for determining 'abnormality' because an extreme result is output. That is, the threshold range may be defined as a criterion indicating a degree to which data contradicts a particular statistical model. The controller 220 may determine, as a noise battery cell, a battery cell having the SOH or the OCV exceeding the threshold among the plurality of battery cells 110, 120, 130, and 140, remove data of the noise battery cell, and identify battery cells from which the noise battery cell is removed as target battery cells.

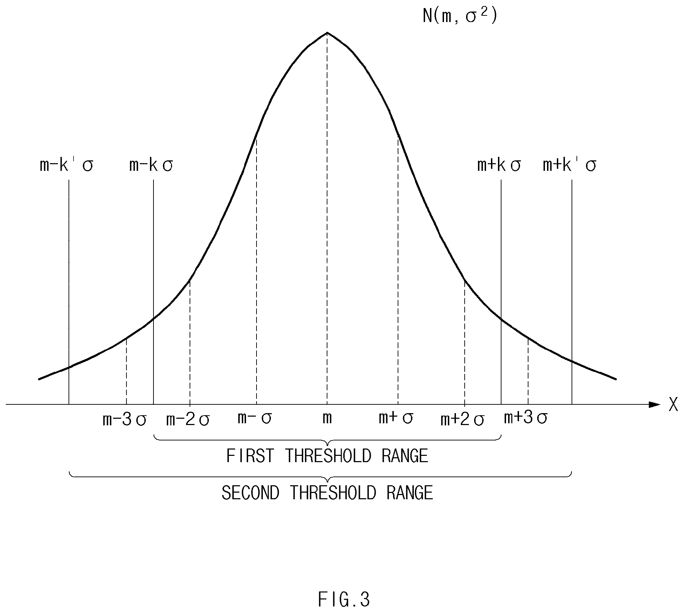

FIG. 3 is a graph showing a threshold range according to an embodiment disclosed herein.

Referring to FIG. 3, the threshold range set by the controller 220 will be described in detail.

The controller 220 may set the threshold range by using a mean m and a standard deviation σ of the SOHs or the OCVs of the plurality of battery cells 110, 120, 130, and 140 included in the battery module 100. The battery module may form a stacked structure with a plurality of battery modules in the battery pack 1000.

Each of the plurality of battery modules may include a plurality of battery cells, and the controller 220 may calculate a mean of SOHs or OCVs of the plurality of battery cells included in each of the plurality of battery modules. That is, the controller 220 may set a threshold range in the unit of a battery module, and identify a target battery cell in the unit of a battery module. According to various embodiments, the battery module 100 may be a battery pack, a battery bank, or a battery cell group, and may include a unit package of a physical or electrical set in which two or more battery cells are coupled in series or in parallel. That is, the controller 220 may set the threshold range for the battery package in which two or more battery cells are coupled, thereby identifying a target battery cell included in the corresponding battery package.

The controller 220 may set a first threshold range for determining whether there is a noise battery cell among the plurality of battery cells 110, 120, 130, and 140 and a second threshold range for determining whether at least one noise battery cell is an abnormal battery cell, by using a mean m and a standard deviation σ of the SOHs or the OCVs of the plurality of battery cells 110, 120, 130, and 140 included in the battery module 100. For example, the controller 220 may set the first threshold range and the second threshold range in a normal distribution form, by using the mean m and the standard deviation σ of the SOHs or the OCVs of the plurality of battery cells 110, 120, 130, and 140 included in the battery module 100.

According to an embodiment, the controller 220 may set the first threshold range and the second threshold range by using the mean m of the SOHs of the plurality of battery cells 110, 120, 130, and 140 included in the battery module 100 and the standard deviation σ of the SOHs of the plurality of battery cells 110, 120, 130, and 140. Specifically, the controller 220 may set the first threshold range by applying a value obtained by multiplying the standard deviation σ of the SOHs of the plurality of battery cells 110, 120, 130, and 140 and a first weight k to the mean m of the SOHs of the plurality of battery cells 110, 120, 130, and 140. For example, the controller 220 may set, as the first threshold range, a range from 'm - kσ' obtained by subtracting a product kσ of the standard deviation σ of the SOHs of the plurality of battery cells 110, 120, 130, and 140 and the first weight k from the mean m of the SOHs of the plurality of battery cells 110, 120, 130, and 140 to 'm + kσ' obtained by adding the product kσ of the standard deviation σ of the SOHs of the plurality of battery cells 110, 120, 130, and 140 and the first weight k to the mean m of the SOHs of the plurality of battery cells 110, 120, 130, and 140.

In addition, the controller 220 may set the second threshold range by applying a value obtained by multiplying the standard deviation σ of the SOHs of the plurality of battery cells 110, 120, 130, and 140 and a second weight k' to the mean m of the SOHs of the plurality of battery cells 110, 120, 130, and 140. For example, the controller 220 may set, as the second threshold range, a range from 'm - k'σ' obtained by subtracting a product k'σ of the standard deviation σ of the SOHs of the plurality of battery cells 110, 120, 130, and 140 and the second weight k' from the mean m of the SOHs of the plurality of battery cells 110, 120, 130, and 140 to 'm + k'σ' obtained by adding the product k'σ of the standard deviation σ of the SOHs of the plurality of battery cells 110, 120, 130, and 140 and the second weight k' to the mean m of the SOHs of the plurality of battery cells 110, 120, 130, and 140.

According to an embodiment, the controller 220 may set the first threshold range and the second threshold range by using OCV data of the plurality of battery cells 110, 120, 130, and 140 included in the battery module 100. Hereinbelow, a detailed description will be made of an operation, performed by the controller 220, of setting the first threshold range and the second threshold range by using the OCV data of the plurality of battery cells 110, 120, 130, and 140.

First, the controller 220 may calculate a mean ($OCV_{avg}$) of the OCVs of the plurality of battery cells 110, 120, 130, and 140 included in the battery module 100. The controller 220 may calculate a difference ($dOCV_{avg}$) of the mean ($OCV_{avg}$) of the OCVs of the plurality of battery cells 110, 120, 130, and 140 included in the battery module 100. For example, the difference ($dOCV_{avg}$) of the mean of the OCVs of the plurality of battery cells 110, 120, 130, and 140 may be a difference in the unit of time h. The controller 220 may calculate the difference ($dOCV_{cell}$) of the OCV of each of the plurality of battery cells 110, 120, 130, and 140 included in the battery module 100, by calculating a voltage of the OCV of each of the plurality of battery cells 110, 120, 130, and 140. For example, the difference ($dOCV_{cell}$) of the OCV of each of the plurality of battery cells 110, 120, 130, and 140 may be a difference in the unit of time h.

The controller 220 may calculate a deviation ($\Delta dV_{cell}$) of the difference ($dOCV_{cell}$) of the OCV of each of the plurality of battery cells 110, 120, 130, and 140 included in the battery module 100 relative to the difference ($dOCV_{avg}$) of the mean of the OCVs of the plurality of battery cells 110, 120, 130, and 140. Hereinbelow, the deviation ($\Delta dV_{cell}$) of the difference ($dOCV_{cell}$) of the OCV of each of the plurality of battery cells 110, 120, 130, and 140 will be described as a first value. The controller 220 may set the first threshold range by applying the value obtained by multiplying the standard deviation σ of the first value ($\Delta dV_{cell}$) of the plurality of battery cells 110, 120, 130, and 140 and the first weight k to a mean m of the first value ($\Delta dV_{cell}$) of each of the plurality of battery cells 110, 120, 130, and 140. For example, the controller 220 may set, as the first threshold range, a range from 'm - kσ' obtained by subtracting a product kσ of the standard deviation σ of the first value ($\Delta dV_{cell}$) of the plurality of battery cells 110, 120, 130, and 140 and the first weight k from the mean m of the first value ($\Delta dV_{cell}$) of the plurality of battery cells 110, 120, 130, and 140 to 'm + kσ' obtained by adding the product kσ of the standard deviation σ of the first value ($\Delta dV_{cell}$) of the plurality of battery cells 110, 120, 130, and 140 and the first weight k to the mean m of the first value ($\Delta dV_{cell}$) of the plurality of battery cells 110, 120, 130, and 140.

The controller 220 may set the second threshold range by applying the value obtained by multiplying the standard deviation σ of the first value ($\Delta dV_{cell}$) of the plurality of battery cells 110, 120, 130, and 140 and the second weight k' to a mean m of the first value ($\Delta dV_{cell}$) of each of the plurality of battery cells 110, 120, 130, and 140. For example, the controller 220 may set, as the second threshold range, a range from 'm - k'σ' obtained by subtracting a product k'σ of the standard deviation σ of the first value ($\Delta dV_{cell}$) of the plurality of battery cells 110, 120, 130, and 140 and the second weight k' from the mean m of the first value ($\Delta dV_{cell}$) of the plurality of battery cells 110, 120, 130, and 140 to 'm + k'σ' obtained by adding the product k'σ of the standard deviation σ of the first value ($\Delta dV_{cell}$) of the plurality of battery cells 110, 120, 130, and 140 and the second weight k' to the mean m of the first value ($\Delta dV_{cell}$) of the plurality of battery cells 110, 120, 130, and 140.

The controller 220 may determine a noise battery cell among the plurality of battery cells 110, 120, 130, and 140, by using the first threshold range. The controller 220 may identify, as target battery cells, the other battery cells than a noise battery cell among the plurality of battery cells 110, 120, 130, and 140. The controller 220 may determine an abnormal battery cell among the at least one noise battery cell, by using the second threshold range. Specifically, the controller 220 may determine, as the noise battery cell, a battery cell having an SOH or a first value ($\Delta dV_{cell}$) exceeding the first threshold range, among the plurality of battery cells 110, 120, 130, and 140. The controller 220 may identify, as target battery cells, the other battery cells than a noise battery cell among the plurality of battery cells 110, 120, 130, and 140.

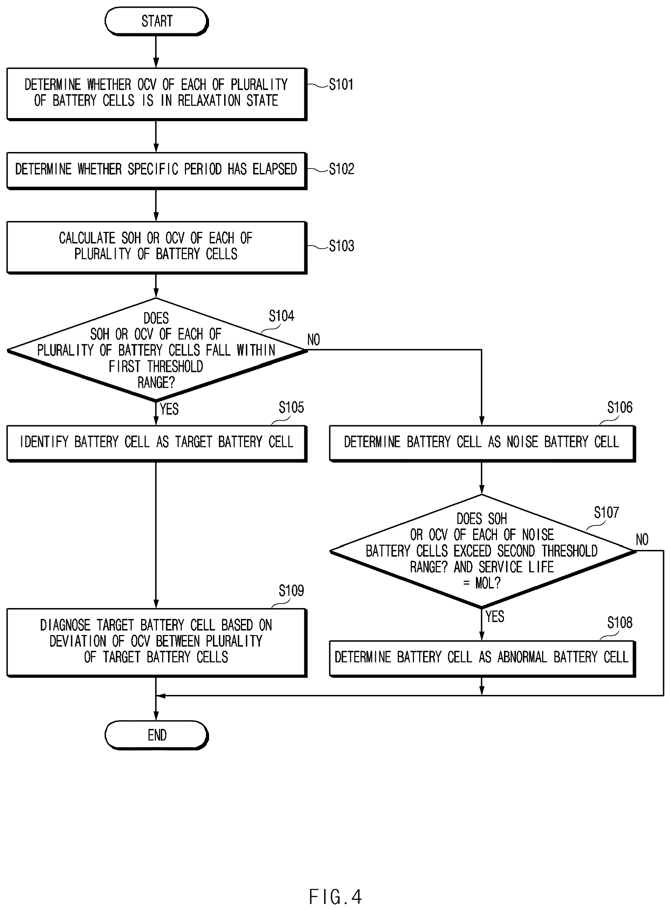

FIG. 4 is a flowchart illustrating a method of identifying a target battery cell of a controller, according to an embodiment disclosed herein.

Hereinbelow, a method, performed by the controller 220, of identifying a target battery cell will be described in detail with reference to FIG. 4.

In operation S101, the controller 220 may determine whether the OCVs of the plurality of battery cells 110, 120, 130, and 140 included in the battery module 100 are in a relaxation state. Herein, voltage relaxation may mean a phenomenon in which a potential difference occurs between a plurality of positive electrode materials when a battery enters an idle state or an unloaded state, and movement of operating ions between the positive electrode materials is caused due to the potential difference, such that the potential difference is resolved over time. In operation S101, for example, when a jitter of a voltage is 20 mV or less for 4 hours in an unloaded state of the voltage of the plurality of battery cells 110, 120, 130, and 140, the controller 220 may determine that the plurality of battery cells 110, 120, 130, and 140 are in a voltage relaxation state.

In operation S102, the controller 220 may determine whether a specific period has elapsed after the plurality of battery cells 110, 120, 130, and 140 are in the voltage relaxation state. In operation S102, for example, the controller 220 may determine whether 10 days have elapsed after the plurality of battery cells 110, 120, 130, and 140 are in the voltage relaxation state.

In operation S103, the controller 220 may measure the SOH or the OCV of each of the plurality of battery cells 110, 120, 130, and 140 after the elapse of a preset specific period.

In operation S104, the controller 220 may determine whether the SOH or the first value ($\Delta dV_{cell}$) of the plurality of battery cells 110, 120, 130, and 140 falls within the first threshold range.

In operation S104, according to an embodiment, the controller 220 may determine whether the SOH of each of the plurality of battery cells 110, 120, 130, and 140 falls within the first threshold range. Herein, the first threshold range may be defined as a range from 'm - kσ' obtained by subtracting a product kσ of the standard deviation σ of the SOHs of the plurality of battery cells 110, 120, 130, and 140 and the first weight k from the mean m of the SOHs of the plurality of battery cells 110, 120, 130, and 140 to 'm + kσ' obtained by adding the product kσ of the standard deviation σ of the SOHs of the plurality of battery cells 110, 120, 130, and 140 and the first weight k to the mean m of the SOHs of the plurality of battery cells 110, 120, 130, and 140. In operation S104, the controller 220 may determine whether each of the plurality of battery cells 110, 120, 130, and 140 is a noise battery cell, based on whether the SOH of each of the plurality of battery cells 110, 120, 130, and 140 falls within the first threshold range.

In operation S104, according to an embodiment, the controller 220 may determine whether the first value ($\Delta dV_{cell}$) of each of the plurality of battery cells 110, 120, 130, and 140 falls within the first threshold range. Herein, the first threshold range may be defined as a range from 'm - kσ' obtained by subtracting the product kσ of the standard deviation σ of the first value ($\Delta dV_{cell}$) of the plurality of battery cells 110, 120, 130, and 140 and the first weight k from the mean m of the first value ($\Delta dV_{cell}$) of the plurality of battery cells 110, 120, 130, and 140 to 'm + kσ' obtained by adding the product kσ of the standard deviation σ of the first value ($\Delta dV_{cell}$) of the plurality of battery cells 110, 120, 130, and 140 and the first weight k to the mean m of the first value ($\Delta dV_{cell}$) of the plurality of battery cells 110, 120, 130, and 140. In operation S104, the controller 220 may determine whether each of the plurality of battery cells 110, 120, 130, and 140 is a noise battery cell, based on whether the first value ($\Delta dV_{cell}$) of each of the plurality of battery cells 110, 120, 130, and 140 falls within the first threshold range.

In operation S105, the controller 220 may identify, as the target battery cell, the at least one battery cell having the SOH or the first value ($\Delta dV_{cell}$) falling within the first threshold range, among the plurality of battery cells 110, 120, 130, and 140.

In operation S106, the controller 220 may determine, as the noise battery cell, the at least one battery cell having the SOH or the first value ($\Delta dV_{cell}$) falling out of the first threshold range, among the plurality of battery cells 110, 120, 130, and 140.

In operation S107, the controller 220 may determine whether the SOH or the first value ($\Delta dV_{cell}$) of each of the plurality of battery cells 110, 120, 130, and 140 exceeds the second threshold range and the service life of each of the plurality of battery cells 110, 120, 130, and 140 corresponds to a middle of life (MOL).

In operation S107, according to an embodiment, the controller 220 may determine whether the SOH of each of the plurality of battery cells 110, 120, 130, and 140 exceeds the second threshold range. Herein, the second threshold range may be defined as a range from 'm - k'σ' obtained by subtracting the product k'σ of the standard deviation σ of the SOHs of the plurality of battery cells 110, 120, 130, and 140 and the second weight k' from the mean m of the SOHs of the plurality of battery cells 110, 120, 130, and 140 to 'm + k'σ' obtained by adding the product k'σ of the standard deviation σ of the SOHs of the plurality of battery cells 110, 120, 130, and 140 and the second weight k' to the mean m of the SOHs of the plurality of battery cells 110, 120, 130, and 140. In operation S107, the controller 220 may determine whether each of the plurality of battery cells 110, 120, 130, and 140 is an abnormal battery cell based on whether the SOH of each of the plurality of battery cells 110, 120, 130, and 140 exceeds the second threshold range and the service life of each of the plurality of battery cells 110, 120, 130, and 140 corresponds to an MOL.

In operation S107, according to an embodiment, the controller 220 may determine whether the first value ($\Delta dV_{cell}$) of each of the plurality of battery cells 110, 120, 130, and 140 exceeds the second threshold range. Herein, the second threshold range may be defined as a range from 'm - k'σ' obtained by subtracting the product k'σ of the standard deviation σ of the first value ($\Delta dV_{cell}$) of the plurality of battery cells 110, 120, 130, and 140 and the second weight k' from the mean m of the first value ($\Delta dV_{cell}$) of the plurality of battery cells 110, 120, 130, and 140 to 'm + k'σ' obtained by adding the product k'σ of the standard deviation σ of the first value ($\Delta dV_{cell}$) of the plurality of battery cells 110, 120, 130, and 140 and the second weight k' to the mean m of the first value ($\Delta dV_{cell}$) of the plurality of battery cells 110, 120, 130, and 140. In operation S107, the controller 220 may determine whether each of the plurality of battery cells 110, 120, 130, and 140 is an abnormal battery cell based on whether the first value ($\Delta dV_{cell}$) of each of the plurality of battery cells 110, 120, 130, and 140 exceeds the second threshold range and the service life of each of the plurality of battery cells 110, 120, 130, and 140 corresponds to an MOL.

In operation S108, the controller 220 may determine, as the abnormal battery cell, the at least one battery cell having the SOH or the first value ($\Delta\ dV_{cell}$) falling out of the second threshold range and having the service life corresponding to the MOL at the same time, among the plurality of battery cells 110, 120, 130, and 140. That is, when the SOH or the first value ($\Delta\ dV_{cell}$) of each of the at least one battery cell among the plurality of battery cells 110, 120, 130, and 140 exceeds the second threshold range and the service life thereof corresponds to the MOL at the same time, the controller 220 may determine that the corresponding battery cell has abnormal degradation due to a defect.

In operation S109, the controller 220 may diagnose at least one target battery cell based on deviations of OCVs between a plurality of target battery cells.

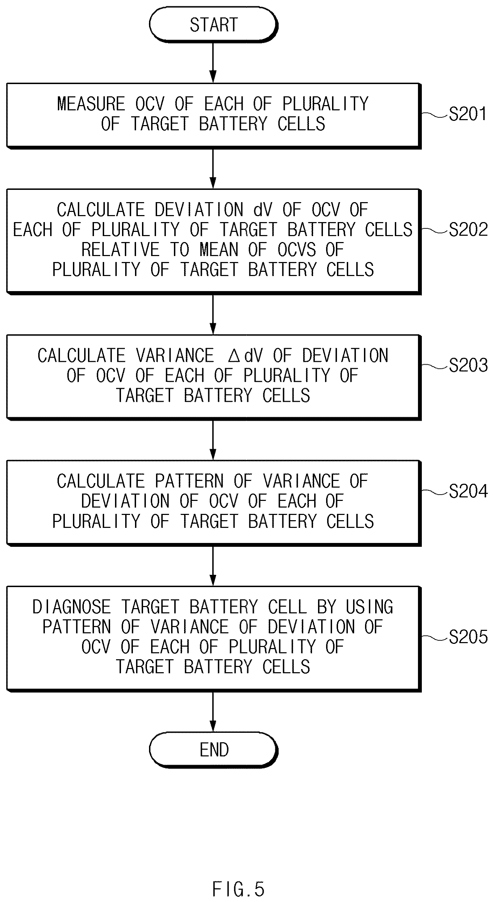

FIG. 5 is a flowchart illustrating a method of diagnosing a target battery cell of a controller, according to an embodiment disclosed herein.

Hereinbelow, referring to FIG. 5, a detailed description will be made of a method, performed by the controller 220, of diagnosing at least one target battery cell based on deviations of OCVs between target battery cells.

In operation S201, the controller 220 may measure an OCV of each of the plurality of target battery cells after a preset period has elapsed.

In operation S202, the controller 220 may calculate a mean of the OCVs of the plurality of target battery cells.

In operation S202, the controller 220 may calculate the deviation dV of the OCV of each of the plurality of target battery cells relative to the mean of the OCVs of each of the plurality of groups. In operation S202, for example, the controller 220 may calculate the deviation of the OCV of each of the plurality of target battery cells relative to a mean Vavg of the OCVs of the plurality of target battery cells included in the battery module 100.

In operation S202, for example, when the current time is set to 'T', the controller 220 may calculate the deviation dV of the OCV of each of the plurality of battery cells at the past times 'T-4', 'T-3', 'T-2', and 'T-1', and the current time 'T'. In operation S202, the controller 220 may calculate a first OCV deviation ($dV_{T-4}$), which is the deviation of the OCV of each target battery cell, calculated at the time 'T-4', a second OCV deviation ($dV_{T-3}$), which is the deviation of the OCV of each target battery cell, calculated at the time 'T-3', a third OCV deviation ($dV_{T-2}$), which is the deviation of the OCV of each target battery cell, calculated at the time 'T-2', a fourth OCV deviation ($dV_{T-1}$), which is the deviation of the OCV of each target battery cell, calculated at the time 'T-1', and a fifth OCV deviation ($dV_T$), which is the deviation of the OCV of each target battery cell, calculated at the time 'T'.

In operation S203, the controller 220 may calculate the difference $\Delta$dV of the deviation of the OCV of each of the plurality of target battery cells. In operation S203, specifically, the controller 220 may continuously calculate an OCV of each of the plurality of target battery cells every specific periods to calculate the difference $\Delta$dV of the deviation of the OCV of each of the plurality of target battery cells, calculated in the current period, relative to the deviation of the OCV of each of the plurality of target battery cells, calculated in a previous period.

In operation S203, the controller 220 may continuously calculate the difference $\Delta$dV of the deviation of the OCV of each of the plurality of target battery cells every specific periods.

In operation S203, for example, the controller 220 may calculate a first voltage deviation difference ($\Delta\ dV_{T-3}$), which is a difference of the second OCV deviation ($dV_{T-3}$) that is the deviation of the OCV of each of the plurality of target battery cells, calculated at the time 'T-3' relative to the first OCV deviation ($dV_{T-4}$) that is the deviation of the OCV of each of the plurality of target battery cells, calculated at the time 'T-4'.

In operation S203, for example, the controller 220 may calculate a second voltage deviation difference ($\Delta\ dV_{T-2}$), which is a difference of the third OCV deviation ($dV_{T-2}$) that is the deviation of the OCV of each of the plurality of target battery cells, calculated at the time 'T-2' relative to the second OCV deviation ($dV_{T-3}$) that is the deviation of the OCV of each of the plurality of target battery cells, calculated at the time 'T-3'.

In operation S203, for example, the controller 220 may calculate a third voltage deviation difference ($\Delta\ dV_{T-1}$), which is a difference of the fourth OCV deviation ($dV_{T-1}$) that is the deviation of the OCV of each of the plurality of target battery cells, calculated at the time 'T-1' relative to the third OCV deviation ($dV_{T-2}$) that is the deviation of the OCV of each of the plurality of target battery cells, calculated at the time 'T-2'.

In operation S203, for example, the controller 220 may calculate a fourth voltage deviation difference ($\Delta\ dV_T$), which is a difference of the fifth OCV deviation ($dV_T$) that is the deviation of the OCV of each of the plurality of target battery cells, calculated at the time 'T' relative to the fourth OCV deviation ($dV_{T-1}$) that is the deviation of the OCV of each of the plurality of target battery cells, calculated at the time 'T-1'.

In operation S204, the controller 220 may calculate a pattern of the difference of the deviation of the OCV of each of the plurality of target battery cells. In operation S204, for example, the controller 220 may calculate the pattern of the difference of the deviation of the OCV of each of the plurality of target battery cells, by using the first voltage deviation difference ($\Delta\ dV_{T-3}$), which is the difference of the deviation of the OCV of each of the plurality of target battery cells, calculated at the time 'T-3', the second voltage deviation difference ($\Delta\ dV_{T-2}$), which is the difference of the deviation of the OCV of each of the plurality of target battery cells, calculated at the time 'T-2', the third voltage deviation difference ($\Delta\ dV_{T-1}$), which is the difference of deviation of the OCV of each of the plurality of target battery cells, calculated at the time 'T-1', and the fourth voltage deviation difference ($\Delta dV_T$), which is the difference of deviation of the OCV of each of the plurality of target battery cells, calculated at the time 'T'.

In operation S205, the controller 220 may diagnose at least one target battery cell by using the pattern of the difference of the deviation of the OCV of each of the plurality of target battery cells. In operation S205, specifically, the controller 220 may diagnose at least one target battery cell based on at least any one of the pattern of the difference of the deviation of the OCV of each of the plurality of target battery cells, and a sum and a magnitude of differences of deviations of the OCVs.

In operation S205, according to an embodiment, the controller 220 may diagnose at least one target battery cell by comparing the pattern of the difference of the deviation of the OCV of each of the plurality of target battery cells with a plurality of pre-stored diagnosis patterns. Herein, the plurality of pre-stored diagnosis patterns may include a pattern of diagnosing a state of a battery cell with respect to a sum of differences of a deviation dV of an OCV of a target battery cell, a pattern of diagnosing the state of the battery cell with respect to a magnitude of each difference of the deviation dV of the OCV of the target battery cell, a pattern of diagnosing the state of the battery cell with respect to a maximum magnitude or a minimum magnitude of the difference of the deviation dV of the OCV of the target battery cell, and a pattern of diagnosing the state of the battery cell with respect to an increase or decrease trend of the difference of the deviation dV of the OCV of the target battery cell.

When a pattern of a difference of a deviation of an OCV of at least one target battery cell among the plurality of target battery cells corresponds to any one of a plurality of diagnosis patterns, the controller 220 may diagnose that an inner short-circuit occurs in the corresponding target battery cell.

When the controller 220 determines that the inner short-circuit occurs in a battery cell, as a result of diagnosis, the controller 220 may provide information about the battery cell to a user. For example, the controller 220 may provide information about the battery cell having internal short-circuit occurring to a user terminal through a communication unit (not shown) and provide the information about the battery cell through a display provided in a vehicle, a charger, etc.

As described above, the battery management apparatus 200 according to an embodiment disclosed herein may accurately diagnose a battery cell having an inner short-circuit occurring, by reflecting a voltage deviation with respect to a difference between SOHs of battery cells.

A conventional battery management apparatus may misdiagnose a battery cell having a voltage deviation with respect to an SOH difference because of ignoring an SOH difference between battery cells, but the battery management apparatus 200 according to an embodiment disclosed herein may identify battery cells having different SOHs as noise battery cells and compare battery cells having similar SOHs, thereby improving the accuracy of diagnosis of an inner short-circuit.

Moreover, the battery management apparatus 200 may compare differences of deviations of a plurality of OCVs of each of a plurality of battery cells to analyze features of short-term voltage behavior and long-term voltage behavior of the battery cells.

The battery management apparatus 200 may secure safety and reliability of battery energy by early diagnosing a battery cell having an inner short-circuit occurring using differences of deviations of OCVs of the battery cells. In addition, the battery management apparatus 200 may diagnose quickly and conveniently the battery cell because of no need to remove the battery cell having the inner short-circuit occurring in the state of the battery being mounted on a vehicle.

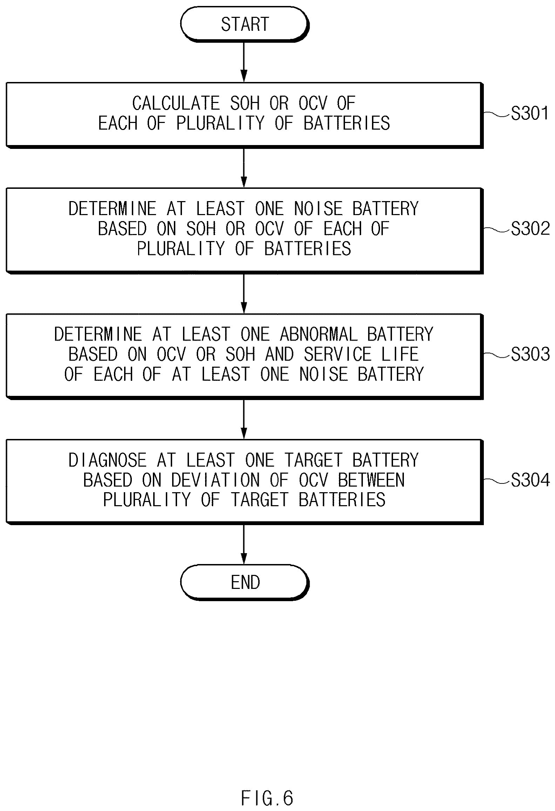

FIG. 6 is a flowchart showing an operating method of a battery management apparatus, according to an embodiment disclosed herein.

Hereinbelow, an operating method of the battery management apparatus 200 will be described with reference to FIGS. 1 to 5.

The battery management apparatus 200 may be substantially the same as the battery management apparatus 200 described with reference to FIGS. 1 to 5, and thus will be briefly described to avoid redundant description.

Referring to FIG. 6, the operating method of the battery management apparatus may include operation S301 of calculating an SOH or an OCV of each of a plurality of batteries, operation S302 of determining at least one noise battery based on the SOH or the OCV of each of the plurality of batteries, operation S303 of determining at least one abnormal battery based on the OCV or the SOH and a service life of the at least one noise battery, and operation S304 of diagnosing at least one target battery based on a deviation of OCVs of a plurality of target batteries.

Hereinbelow, operations S301 through S304 will be described in detail.

In operation S301, the data management unit 210 may calculate an SOH or OCV of each of the plurality of battery cells 110, 120, 130, and 140.

Herein, the OCV may mean a voltage measured when the current of the battery does not flow. That is, the OCV may be a voltage between both electrodes in a state where a fuel electrode (anode) and an air electrode (cathode) of the battery are not electrically connected to each other. According to the Ohm's law, as the battery's resistance increases infinitely, the current may approach '0', thereby accurately measuring a voltage of the battery. In operation S301, thus, the data management unit 210 may measure the OCVs of the plurality of battery cells 110, 120, 130, and 140 for accurate electrochemical analysis of the plurality of battery cells 110, 120, 130, and 140.

The SOH is an index indicating a health state or life state of the battery in the current state with respect to an initial state of the battery. A moment at which the SOH reaches 0 % may be defined as an end of life (EOL). In addition, the end of life of the battery may be a moment at which the capacity of the battery reaches a guaranteed capacity or less. In operation S301, for example, the data management unit 210 may calculate the SOH of the plurality of battery cells 110, 120, 130, and 140 based on at least one factor of internal resistance, impedance, conductance, capacity, voltage, self-discharge current, charge performance, and the number of times of charge and discharge of the plurality of battery cells 110, 120, 130, and 140, which change with deterioration of the plurality of battery cells 110, 120, 130, and 140.

In operation S301, for example, the data management unit 210 may calculate an individual SOH, i.e., an SOHC of each battery cell by using the OCVs and current integrated value of the plurality of battery cells 110, 120, 130, and 140. In operation S301, specifically, the battery management apparatus 200 may calculate before-charge $OCV_A$ and after-charge $OCV_B$ of the plurality of battery cells 110, 120, 130, and 140.

In operation S301, the data management unit 210 may calculate $SOC_A$ and $SOC_B$ by changing $OCV_A$ and $OCV_B$ into the amount of charge, i.e., SOCs, based on an OCV table. In operation S301, the battery management apparatus 200 may calculate individual SOHs of the plurality of battery cells 110, 120, 130, and 140, based on [Equation 2].

[Equation 2]

$$SOHC = \frac{I}{(SOC_B - SOC_A)/100 \times X} \times 100$$

Herein, $(SOC_B - SOC_A)$ may mean an SOC deviation, I may mean an accumulated charging current, and X may mean a capacity of an existing battery cell. The data management unit 210 may calculate an individual SOH, i.e., an SOHC, of each of the plurality of battery cells 110, 120, 130, and 140, based on [Equation 2].

In operation S302, the controller 220 may determine at least one noise battery cell among the plurality of battery cells 110, 120, 130, and 140, based on an SOHC or an OCV of each of the plurality of battery cells 110, 120, 130, and 140. In operation S302, after determining the at least one noise battery cell based on the SOHC or the OCV of each of the plurality of battery cells 110, 120, 130, and 140, the controller 220 may identify a plurality of target battery cells except for the at least one noise battery cell from among the plurality of battery cells 110, 120, 130, and 140.

In operation S302, the controller 220 may set a threshold range for identifying a target battery cell among the plurality of battery cells 110, 120, 130, and 140 by using the mean and the standard deviation σ of the SOHs or the OCVs of the plurality of battery cells 110, 120, 130, and 140.

In operation S302, the controller 220 may set the first threshold range by using the mean m and the standard deviation σ of the SOHs or the OCVs of the plurality of battery cells 110, 120, 130, and 140 included in the battery module 100. The battery module may form a stacked structure with a plurality of battery modules in the battery pack 1000. Each of the plurality of battery modules may include a plurality of battery cells, and the controller 220 may calculate a mean of SOHs or OCVs of the plurality of battery cells included in each of the plurality of battery modules. According to various embodiments, the battery module 100 may be a battery pack, a battery bank, or a battery cell group, and may include a unit package of a physical or electrical set in which two or more battery cells are coupled in series or in parallel.

In operation S302, according to an embodiment, the controller 220 may set the first threshold range by using the mean m of the SOHs of the plurality of battery cells 110, 120, 130, and 140 included in the battery module 100 and the standard deviation σ of the SOHs of the plurality of battery cells 110, 120, 130, and 140. In operation S302, specifically, the controller 220 may set the first threshold range by applying a value obtained by multiplying the standard deviation σ of the SOHs of the plurality of battery cells 110, 120, 130, and 140 and a first weight k to the mean m of the SOHs of the plurality of battery cells 110, 120, 130, and 140. In operation S302, for example, the controller 220 may set, as the first threshold range, a range from 'm - kσ' obtained by subtracting a product kσ of the standard deviation σ of the SOHs of the plurality of battery cells 110, 120, 130, and 140 and the first weight k from the mean m of the SOHs of the plurality of battery cells 110, 120, 130, and 140 to 'm + kσ' obtained by adding the product kσ of the standard deviation σ of the SOHs of the plurality of battery cells 110, 120, 130, and 140 and the first weight k to the mean m of the SOHs of the plurality of battery cells 110, 120, 130, and 140.

In operation S302, according to an embodiment, the controller 220 may set the first threshold range by using OCV data of the plurality of battery cells 110, 120, 130, and 140 included in the battery module 100. In operation S302, first, the controller 220 may calculate a mean ($OCV_{avg}$) of the OCVs of the plurality of battery cells 110, 120, 130, and 140 included in the battery module 100. In operation S302, the controller 220 may calculate a difference ($dOCV_{avg}$) of the mean ($OCV_{avg}$) of the OCVs of the plurality of battery cells 110, 120, 130, and 140 included in the battery module 100. In operation S302, the controller 220 may calculate the difference ($dOCV_{cell}$) of the OCV of each of the plurality of battery cells 110, 120, 130, and 140 included in the battery module 100, by calculating a voltage of the OCV of each of the plurality of battery cells 110, 120, 130, and 140.

In operation S302, the controller 220 may cal-

culate a deviation ($\Delta dV_{cell}$) of the difference ($dOCV_{cell}$) of the OCV of each of the plurality of battery cells 110, 120, 130, and 140 included in the battery module 100 relative to the difference ($dOCV_{avg}$) of the mean of the OCVs of the plurality of battery cells 110, 120, 130, and 140. Hereinbelow, the deviation of the difference of the OCV of each of the plurality of battery cells 110, 120, 130, and 140 will be described as a first value. In operation S302, the controller 220 may set the first threshold range by applying the value obtained by multiplying the standard deviation $\sigma$ of the first value ($\Delta dV_{cell}$) of the plurality of battery cells 110, 120, 130, and 140 and the first weight k to a mean m of the first value ($\Delta dV_{cell}$) of each of the plurality of battery cells 110, 120, 130, and 140. In operation S302, for example, the controller 220 may set, as the first threshold range, a range from 'm - k$\sigma$' obtained by subtracting a product k$\sigma$ of the standard deviation $\sigma$ of the first value ($\Delta dV_{cell}$) of the plurality of battery cells 110, 120, 130, and 140 and the first weight k from the mean m of the first value ($\Delta dV_{cell}$) of the plurality of battery cells 110, 120, 130, and 140 to 'm + k$\sigma$' obtained by adding the product k$\sigma$ of the standard deviation $\sigma$ of the first value ($\Delta dV_{cell}$) of the plurality of battery cells 110, 120, 130, and 140 and the first weight k to the mean m of the first value ($\Delta dV_{cell}$) of the plurality of battery cells 110, 120, 130, and 140.

In operation S302, the controller 220 may determine a noise battery cell among the plurality of battery cells 110, 120, 130, and 140, by using the first threshold range. In operation S302, the controller 220 may identify, as target battery cells, the other battery cells than a noise battery cell among the plurality of battery cells 110, 120, 130, and 140. In operation S302, specifically, the controller 220 may determine, as the noise battery cell, a battery cell having an SOH or a first value ($\Delta dV_{cell}$) exceeding the first threshold range, among the plurality of battery cells 110, 120, 130, and 140. The controller 220 may identify, as target battery cells, the other battery cells than a noise battery cell among the plurality of battery cells 110, 120, 130, and 140.

In operation S303, the controller 220 may determine an abnormal battery cell among the at least one noise battery cell, by using the second threshold range.

In operation S303, the controller 220 may set the second threshold range by applying a value obtained by multiplying the standard deviation $\sigma$ of the SOHs of the plurality of battery cells 110, 120, 130, and 140 and the second weight k' to the mean m of the SOHs of the plurality of battery cells 110, 120, 130, and 140. In operation S303, for example, the controller 220 may set, as the second threshold range, a range from 'm - k'$\sigma$' obtained by subtracting a product k'$\sigma$ of the standard deviation $\sigma$ of the SOHs of the plurality of battery cells 110, 120, 130, and 140 and the second weight k' from the mean m of the SOHs of the plurality of battery cells 110, 120, 130, and 140 to 'm + k'$\sigma$' obtained by adding the product k'$\sigma$ of the standard deviation $\sigma$ of the SOHs of the plurality of battery cells 110, 120, 130, and 140 and the second weight k' to the mean m of the SOHs of the plurality of battery cells 110, 120, 130, and 140.

In operation S303, the controller 220 may set the second threshold range by applying the value obtained by multiplying the standard deviation $\sigma$ of the first value ($\Delta dV_{cell}$) of the plurality of battery cells 110, 120, 130, and 140 and the second weight k' to a mean m of the first value ($\Delta dV_{cell}$) of each of the plurality of battery cells 110, 120, 130, and 140. In operation S303, for example, the controller 220 may set, as the second threshold range, a range from 'm - k'$\sigma$' obtained by subtracting a product k'$\sigma$ of the standard deviation $\sigma$ of the first value ($\Delta dV_{cell}$) of the plurality of battery cells 110, 120, 130, and 140 and the second weight k' from the mean m of the first value ($\Delta dV_{cell}$) of the plurality of battery cells 110, 120, 130, and 140 to 'm + k'$\sigma$' obtained by adding the product k'$\sigma$ of the standard deviation $\sigma$ of the first value ($\Delta dV_{cell}$) of the plurality of battery cells 110, 120, 130, and 140 and the second weight k' to the mean m of the first value ($\Delta dV_{cell}$) of the plurality of battery cells 110, 120, 130, and 140.

In operation S303, the controller 220 may determine whether the SOH or the first value ($\Delta dV_{cell}$) of each of the plurality of battery cells 110, 120, 130, and 140 exceeds the second threshold range and the service life of each of the plurality of battery cells 110, 120, 130, and 140 corresponds to an MOL. In operation S303, the controller 220 may determine, as the abnormal battery cell, the at least one battery cell having the SOH or the first value falling out of the second threshold range and having the service life corresponding to the MOL at the same time, among the plurality of battery cells 110, 120, 130, and 140. That is, when the SOH or the first value ($\Delta dV_{cell}$) of each of the at least one battery cell among the plurality of battery cells 110, 120, 130, and 140 exceeds the second threshold range and the service life thereof corresponds to the MOL at the same time, the controller 220 may determine that the corresponding battery cell has abnormal degradation due to a defect.

In operation S304, the controller 220 may diagnose at least one target battery cell based on deviations of OCVs between a plurality of target battery cells.

In operation S304, the controller 220 may determine whether the OCVs of the plurality of battery cells 110, 120, 130, and 140 included in the battery module 100 are in a relaxation state.

In operation S304, the controller 220 may diagnose at least one target battery cell based on deviations of OCVs between a plurality of target battery cells. In operation S304, the controller 220 may calculate a mean of the OCVs of the plurality of target battery cells. In operation S304, the controller 220 may calculate the deviation dV of the OCV of each of the plurality of target battery cells relative to the mean of the OCVs of each of the plurality of groups. In operation S304, for example, the controller 220 may calculate the deviation of the OCV of each of the plurality of target battery cells relative to a mean Vavg of the OCVs of the plurality of target battery cells included in the battery module 100.

In operation S304, for example, when the current time is set to 'T', the controller 220 may calculate the deviation dV of the OCV of each of the plurality of battery cells at the past times 'T-4', 'T-3', 'T-2', and 'T-1', and the current time 'T'. In operation S304, the controller 220 may calculate a first OCV deviation ( $dV_{T-4}$ ), which is the deviation of the OCV of each target battery cell, calculated at the time 'T-4', a second OCV deviation ( $dV_{T-3}$ ), which is the deviation of the OCV of each target battery cell, calculated at the time 'T-3', a third OCV deviation ( $dV_{T-2}$ ), which is the deviation of the OCV of each target battery cell, calculated at the time 'T-2', a fourth OCV deviation ( $dV_{T-1}$ ), which is the deviation of the OCV of each target battery cell, calculated at the time 'T-1', and a fifth OCV deviation ( $dV_T$ ), which is the deviation of the OCV of each target battery cell, calculated at the time 'T'.

In operation S304, the controller 220 may calculate the difference ΔdV of the deviation of the OCV of each of the plurality of target battery cells. In operation S304, specifically, the controller 220 may continuously calculate an OCV of each of the plurality of target battery cells every specific periods to calculate the difference ΔdV of the deviation of the OCV of each of the plurality of target battery cells, calculated in the current period, relative to the deviation of the OCV of each of the plurality of target battery cells, calculated in a previous period.

In operation S304, the controller 220 may continuously calculate the difference ΔdV of the deviation of the OCV of each of the plurality of target battery cells every specific periods.

In operation S304, for example, the controller 220 may calculate the first voltage deviation difference (Δ $dV_{T-3}$ ), which is a difference of the second OCV ( $dV_{T-3}$ ) that is the deviation of the OCV of each of the plurality of target battery cells, calculated at the time 'T-3' relative to the first OCV deviation ( $dV_{T-4}$ ) that is the deviation of the OCV of each of the plurality of target battery cells, calculated at the time 'T-4'.

In operation S304, for example, the controller 220 may calculate a second voltage deviation difference (Δ $dV_{T-2}$ ), which is a difference of the third OCV deviation ( $dV_{T-2}$ ) that is the deviation of the OCV of each of the plurality of target battery cells, calculated at the time 'T-2' relative to the second OCV deviation ( $dV_{T-3}$ ) that is the deviation of the OCV of each of the plurality of target battery cells, calculated at the time 'T-3'.

In operation S304, for example, the controller 220 may calculate a third voltage deviation difference (Δ $dV_{T-1}$ ), which is a difference of the fourth OCV deviation ( $dV_{T-1}$ ) that is the deviation of the OCV of each of the plurality of target battery cells, calculated at the time 'T-1' relative to the third OCV deviation ( $dV_{T-2}$ ) that is the deviation of the OCV of each of the plurality of target battery cells, calculated at the time 'T-2'.

In operation S304, for example, the controller 220 may calculate a fourth voltage deviation difference (Δ $dV_T$ ), which is a difference of the fifth OCV deviation ( $dV_T$ ) that is the deviation of the OCV of each of the plurality of target battery cells, calculated at the time 'T' relative to the fourth OCV deviation ( $dV_{T-1}$ ) that is the deviation of the OCV of each of the plurality of target battery cells, calculated at the time 'T-1'.

In operation S304, the controller 220 may calculate a pattern of the difference of the deviation of the OCV of each of the plurality of target battery cells. In operation S304, for example, the controller 220 may calculate the pattern of the difference of the deviation of the OCV of each of the plurality of target battery cells, by using the first voltage deviation difference (Δ $dV_{T-3}$ ), which is the difference of the deviation of the OCV of each of the plurality of target battery cells, calculated at the time 'T-3', the second voltage deviation difference (Δ $dV_{T-2}$ ), which is the difference of the deviation of the OCV of each of the plurality of target battery cells, calculated at the time 'T-2', the third voltage deviation difference (Δ $dV_{T-1}$ ), which is the difference of the deviation of the OCV of each of the plurality of target battery cells, calculated at the time 'T-1', and the fourth voltage deviation difference (Δ $dV_T$ ), which is the difference of deviation of the OCV of each of the plurality of target battery cells, calculated at the time 'T'.

In operation S304, the controller 220 may diagnose at least one target battery cell by using the pattern of the difference of the deviation of the OCV of each of the plurality of target battery cells. In operation S304, specifically, the controller 220 may diagnose at least one target battery cell based on at least any one of the pattern of the difference of the deviation of the OCV of each of the plurality of target battery cells, and a sum and a magnitude of differences of deviations of the OCVs.

In operation S304, according to an embodiment, the controller 220 may diagnose at least one target battery cell by comparing the pattern of the difference of the deviation of the OCV of each of the plurality of target battery cells with a plurality of pre-stored diagnosis patterns. Herein, the plurality of pre-stored diagnosis patterns may include a pattern of diagnosing a state of a battery cell with respect to a sum of differences of a deviation dV of an OCV of a target battery cell, a pattern of diagnosing the state of the battery cell with respect to a magnitude of each difference of the deviation dV of the OCV of the target battery cell, a pattern of diagnosing the state of the battery cell with respect to a maximum magnitude or a minimum magnitude of the difference of the deviation dV of the OCV of the target battery cell, and a pattern of diagnosing the state of the battery cell with respect to an increase or decrease trend of the difference of the deviation dV of the OCV of the target battery cell.

In operation S304, when a pattern of a difference of a deviation of an OCV of at least one target battery cell among the plurality of target battery cells corresponds to any one of a plurality of diagnosis patterns, the controller 220 may diagnose that an inner short-circuit occurs in the corresponding target battery cell.

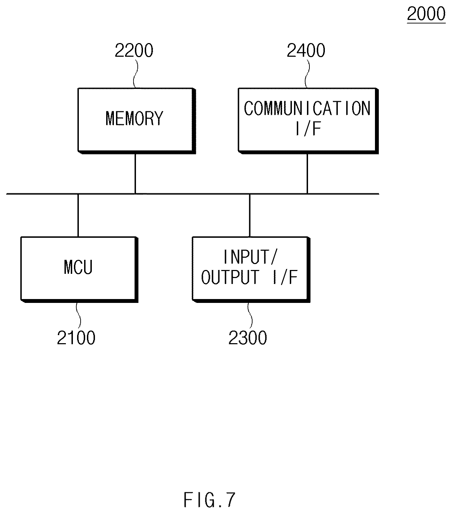

FIG. 7 is a block diagram showing a hardware configuration of a computing system for performing an operating method of a battery management apparatus, according to an embodiment disclosed herein.

Referring to FIG. 7, a computing system 2000 according to an embodiment disclosed herein may include an MCU 2100, a memory 2200, an input/output I/F 2300, and a communication I/F 2400.

The MCU 2100 may be a processor that executes various programs (e.g., a battery voltage change amount analysis program, etc.) stored in the memory 2200, processes various data through these programs, and perform the above-described functions of the battery management apparatus 200 shown in FIG. 1.

The memory 2200 may store various programs regarding operations of the battery management apparatus 200. Moreover, the memory 2200 may store operation data of the battery management apparatus 200.

The memory 2200 may be provided in plural, depending on a need. The memory 2200 may be volatile memory or non-volatile memory. For the memory 2200 as the volatile memory, random access memory (RAM), dynamic RAM (DRAM), static RAM (SRAM), etc., may be used. For the memory 2200 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 2200 are merely examples and are not limited thereto.

The input/output I/F 2300 may provide an interface for transmitting and receiving data by connecting an input device (not shown) such as a keyboard, a mouse, a touch panel, etc., and an output device such as a display (not shown), etc., to the MCU 2100.

The communication I/F 2400, which is a component capable of transmitting and receiving various data to and from a server, may be various devices capable of supporting wired or wireless communication. For example, a program for resistance measurement and abnormality diagnosis of the battery cell or various data may be transmitted and received to and from a separately provided external server through the communication I/F 2400.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present disclosure are intended for description rather than limitation of the technical spirit of the present disclosure and the scope of the technical spirit of the present disclosure is not limited by these embodiments. The protection scope of the present disclosure should be interpreted by the following claims, and all technical spirits within the same range should be understood to be included in the range of the present disclosure.

[DESCRIPTION OF SYMBOLS]

1000: Battery Pack
100: Battery Module
110: First Battery Cell
120: Second Battery Cell
130: Third Battery Cell
140: Fourth Battery Cell
200: Battery Management Apparatus
210: Data Management Unit
220: Controller
300: Relay
2000: Computing System
2100: MCU
2200: Memory
2300: Input/Output I/F
2400: Communication I/F

**Claims**

1. A battery management apparatus comprising:

   a data management unit configured to calculate a degradation degree (a state of health (SOH)) or an open circuit voltage (OCV) of each of a plurality of batteries; and
   a controller configured to:

      determine at least one noise battery based on the SOH or the OCV of each of the plurality of batteries;
      determine at least one abnormal battery based on an SOH or an OCV of each of the at least one noise battery and a service life of each of the at least one noise battery; and
      diagnose at least one target battery based on a deviation of OCVs between a plurality of target batteries except for the at least one noise battery, among the plurality of batteries.

2. The battery management apparatus of claim 1, wherein the controller is further configured to determine, as the at least one noise battery, a battery having an SOH or an OCV falling out of a first threshold range, among the plurality of batteries.

3. The battery management apparatus of claim 2, wherein the controller is further configured to determine, as the at least one abnormal battery, a noise battery having a service life corresponding to a middle of life (MOL) and an SOH or an OCV falling out of a second threshold range, among the at least one noise battery.

4. The battery management apparatus of claim 3, wherein the controller is further configured to set the first threshold range by applying a value obtained by multiplying a standard deviation of the SOHs of the plurality of batteries and a first weight to a mean of SOHs of the plurality of batteries.

5. The battery management apparatus of claim 4, wherein the controller is further configured to set the second threshold range by applying a value obtained by multiplying the standard deviation of the SOHs of the plurality of batteries and a second weight to the mean of the SOHs of the plurality of batteries.

6. The battery management apparatus of claim 3, wherein the controller is further configured to:

   calculate a first value which is a deviation of a difference of an OCV of each of the plurality of batteries relative to a difference of a mean of OCVs of the plurality of batteries; and set the first threshold range by applying a value obtained by multiplying a standard deviation of the first values of the plurality of batteries and a first weight to a mean of first values of the plurality of batteries.

7. The battery management apparatus of claim 6, wherein the controller is further configured to set the second threshold range by applying a value obtained by multiplying the standard deviation of the first values of the plurality of batteries and a second weight to the mean of the first values of the plurality of batteries.

8. The battery management apparatus of claim 3, wherein the controller is further configured to calculate a deviation of an OCV of each of the plurality of target batteries relative to a mean of OCVs of the plurality of target batteries and calculate a difference of the deviation of the OCV of each of the plurality of target batteries.

9. The battery management apparatus of claim 8, wherein the controller is further configured to:

   calculate a pattern of the difference of the deviation of the OCV of each of the plurality of target batteries by calculating the difference of the deviation of the OCV of each of the plurality of target batteries every specific periods; and diagnose the at least one target battery by comparing the pattern of the difference of the deviation of the OCV of each of the plurality of target batteries with a plurality of diagnosis patterns.

10. The battery management apparatus of claim 9, wherein the controller is further configured to diagnose at least one target battery among the plurality of target batteries when a pattern of a difference of a deviation of an OCV of the at least one target battery corresponds to any one of the plurality of diagnosis patterns.

11. An operating method of a battery management apparatus, the operating method comprising:

   calculating a degradation degree (a state of health (SOH)) or an open circuit voltage (OCV) of each of a plurality of batteries; determining at least one noise battery based on the SOH or the OCV of each of the plurality of batteries; determining at least one abnormal battery based on an SOH or an OCV of each of the at least one noise battery and a service life of each of the at least one noise battery; and diagnosing at least one target battery based on a deviation of OCVs between a plurality of target batteries except for the at least one noise battery, among the plurality of batteries.

12. The operating method of a battery management apparatus of claim 11, wherein the determining of the at least one noise battery based on the SOH or the OCV of each of the plurality of batteries comprises determining, as the at least one noise battery, a battery having an SOH or an OCV falling out of a first threshold range, among the plurality of batteries.

13. The operating method of a battery management apparatus of claim 12, wherein the determining of the at least one abnormal battery based on the SOH or the OCV of each of the at least one noise battery and the service life of each of the at least one noise battery comprises determining, as the at least one abnormal battery, a noise battery having a service life corresponding to a middle of life (MOL) and an SOH or an OCV falling out of a second threshold range, among the at least one noise battery.

14. The operating method of a battery management apparatus of claim 13, wherein the determining of the at least one noise battery based on the SOH or the OCV of each of the plurality of batteries comprises setting the first threshold range by applying a value obtained by multiplying a standard deviation of the SOHs of the plurality of batteries and a first weight to a mean of SOHs of the plurality of batteries.

15. The operating method of a battery management apparatus of claim 14, wherein the determining of the at least one abnormal battery based on the SOH or the OCV of each of the at least one noise battery and the service life of each of the at least one noise battery comprises setting the second threshold range by applying a value obtained by multiplying the standard deviation of the SOHs of the plurality of batteries and a second weight to the mean of the SOHs of the plurality of batteries.

16. The operating method of a battery management apparatus of claim 13, wherein the determining of the at least one noise battery based on the SOH or the OCV of each of the plurality of batteries comprises:

calculating a first value which is a deviation of a difference of an OCV of each of the plurality of batteries relative to a difference of a mean of OCVs of the plurality of batteries; and setting the first threshold range by applying a value obtained by multiplying a standard deviation of the first values of the plurality of batteries and a first weight to a mean of first values of the plurality of batteries.

17. The operating method of a battery management apparatus of claim 16, wherein the determining of the at least one abnormal battery based on the SOH or the OCV of each of the at least one noise battery and the service life of each of the at least one noise battery comprises setting the second threshold range by applying a value obtained by multiplying the standard deviation of the first values of the plurality of batteries and a second weight to the mean of the first values of the plurality of batteries.

18. The operating method of a battery management apparatus of claim 14, wherein the diagnosing of the at least one target battery based on the deviation of OCVs between the plurality of target batteries except for the at least one noise battery, among the plurality of batteries, comprises calculating a deviation of an OCV of each of the plurality of target batteries relative to a mean of OCVs of the plurality of target batteries and calculating a difference of the deviation of the OCV of each of the plurality of target batteries.

19. The operating method of a battery management apparatus of claim 18, wherein the diagnosing of the at least one target battery based on the deviation of OCVs between the plurality of target batteries except for the at least one noise battery, among the plurality of batteries, comprises:

calculating a pattern of the difference of the deviation of the OCV of each of the plurality of target batteries by calculating the difference of the deviation of the OCV of each of the plurality of target batteries every specific periods; and diagnosing the at least one target battery by comparing the pattern of the difference of the deviation of the OCV of each of the plurality of target batteries with a plurality of diagnosis patterns.

20. The operating method of a battery management apparatus of claim 19, wherein the diagnosing of the at least one target battery based on the deviation of OCVs between the plurality of target batteries except for the at least one noise battery, among the plurality of batteries, comprises diagnosing at least one target battery among the plurality of target batteries when a pattern of a difference of a deviation of an OCV of the at least one target battery corresponds to any one of the plurality of diagnosis patterns.

300

1000

100

110

120

130

·
·
·

140

BATTERY MANAGEMENT
APPARATUS
200

FIG.1

200

| DATA MANAGEMENT UNIT 210 | CONTROLLER 220 |
|---|---|

FIG.2

$N(m, \sigma^2)$

m−k′σ   m−kσ   m+kσ   m+k′σ

X

m−3σ   m−2σ   m−σ   m   m+σ   m+2σ   m+3σ

FIRST THRESHOLD RANGE

SECOND THRESHOLD RANGE

FIG.3

START

DETERMINE WHETHER OCV OF EACH OF PLURALITY OF BATTERY CELLS IS IN RELAXATION STATE — S101

DETERMINE WHETHER SPECIFIC PERIOD HAS ELAPSED — S102

CALCULATE SOH OR OCV OF EACH OF PLURALITY OF BATTERY CELLS — S103

S104

DOES SOH OR OCV OF EACH OF PLURALITY OF BATTERY CELLS FALL WITHIN FIRST THRESHOLD RANGE?

NO

YES

S105

IDENTIFY BATTERY CELL AS TARGET BATTERY CELL

S106

DETERMINE BATTERY CELL AS NOISE BATTERY CELL

S107

DOES SOH OR OCV OF EACH OF NOISE BATTERY CELLS EXCEED SECOND THRESHOLD RANGE? AND SERVICE LIFE = MOL?

NO

YES

S108

DETERMINE BATTERY CELL AS ABNORMAL BATTERY CELL

S109

DIAGNOSE TARGET BATTERY CELL BASED ON DEVIATION OF OCV BETWEEN PLURALITY OF TARGET BATTERY CELLS

END

FIG.4

START

MEASURE OCV OF EACH OF PLURALITY
OF TARGET BATTERY CELLS — S201

CALCULATE DEVIATION dV OF OCV OF
EACH OF PLURALITY OF TARGET BATTERY CELLS — S202
RELATIVE TO MEAN OF OCVS OF
PLURALITY OF TARGET BATTERY CELLS

CALCULATE VARIANCE △dV OF DEVIATION
OF OCV OF EACH OF PLURALITY OF — S203
TARGET BATTERY CELLS

CALCULATE PATTERN OF VARIANCE OF
DEVIATION OF OCV OF EACH OF — S204
PLURALITY OF TARGET BATTERY CELLS

DIAGNOSE TARGET BATTERY CELL BY USING
PATTERN OF VARIANCE OF DEVIATION OF
OCV OF EACH OF PLURALITY OF — S205
TARGET BATTERY CELLS

END

FIG.5

START

CALCULATE SOH OR OCV OF
EACH OF PLURALITY OF BATTERIES ～S301

DETERMINE AT LEAST ONE NOISE BATTERY
BASED ON SOH OR OCV OF EACH OF
PLURALITY OF BATTERIES ～S302

DETERMINE AT LEAST ONE ABNORMAL BATTERY
BASED ON OCV OR SOH AND SERVICE LIFE
OF EACH OF AT LEAST ONE NOISE BATTERY ～S303

DIAGNOSE AT LEAST ONE TARGET BATTERY
BASED ON DEVIATION OF OCV BETWEEN
PLURALITY OF TARGET BATTERIES ～S304

END

FIG.6

2000

2200

2400

MEMORY

COMMUNICATION
I/F

MCU

INPUT/
OUTPUT I/F

2100

2300

FIG.7

## INTERNATIONAL SEARCH REPORT

| | International application No. |
|---|---|
| | **PCT/KR2024/003173** |

**A.    CLASSIFICATION OF SUBJECT MATTER**

**G01R 31/392**(2019.01)i; **G01R 31/385**(2019.01)i; **G01R 31/52**(2020.01)i; **G01R 19/10**(2006.01)i; **G01R 19/00**(2006.01)i; **G01R 19/165**(2006.01)i; **G01R 19/12**(2006.01)i

According to International Patent Classification (IPC) or to both national classification and IPC

**B.    FIELDS SEARCHED**

Minimum documentation searched (classification system followed by classification symbols)

G01R 31/392(2019.01); G01R 19/00(2006.01); G01R 31/36(2006.01); G01R 31/367(2019.01); G01R 31/387(2019.01); G06F 17/11(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 퇴화도(SOH, State Of Health), 개방 회로 전압(OCV, Open Circuit Voltage), 노이즈 배터리(noise battery), 타겟 배터리(target battery), 진단(diagnosis)

**C.    DOCUMENTS CONSIDERED TO BE RELEVANT**

| Category* | Citation of document, with indication, where appropriate, of the relevant passages | Relevant to claim No. |
|---|---|---|
| A | KR 10-2022-0058250 A (LG ENERGY SOLUTION, LTD.) 09 May 2022 (2022-05-09)<br>See paragraph [0049]; claim 1; and figure 2. | 1-20 |
| A | KR 10-2022-0060931 A (LG ENERGY SOLUTION, LTD.) 12 May 2022 (2022-05-12)<br>See claims 1-4; and figure 4. | 1-20 |
| A | KR 10-2022-0045451 A (LG ENERGY SOLUTION, LTD.) 12 April 2022 (2022-04-12)<br>See paragraphs [0183]-[0196]; and figures 1 and 7. | 1-20 |
| A | KR 10-2021-0066609 A (LG CHEM, LTD.) 07 June 2021 (2021-06-07)<br>See paragraphs [0057]-[0062]; and figure 4. | 1-20 |
| A | US 2019-0033376 A1 (SAMSUNG ELECTRONICS CO., LTD.) 31 January 2019 (2019-01-31)<br>See paragraphs [0051]-[0080]; and figure 2. | 1-20 |

☐ Further documents are listed in the continuation of Box C.         ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **25 June 2024** | **27 June 2024** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

# EP 4 671 791 A1

| INTERNATIONAL SEARCH REPORT | International application No. |
| Information on patent family members | PCT/KR2024/003173 |

| Patent document cited in search report | | | Publication date (day/month/year) | Patent family member(s) | | | Publication date (day/month/year) |
|---|---|---|---|---|---|---|---|
| KR | 10-2022-0058250 | A | 09 May 2022 | CN | 116368391 | A | 30 June 2023 |
| | | | | EP | 4206712 | A1 | 05 July 2023 |
| | | | | EP | 4206712 | A4 | 13 March 2024 |
| | | | | JP | 2023-543747 | A | 18 October 2023 |
| | | | | US | 2024-0012065 | A1 | 11 January 2024 |
| | | | | WO | 2022-092621 | A1 | 05 May 2022 |
| KR | 10-2022-0060931 | A | 12 May 2022 | None | | | |
| KR | 10-2022-0045451 | A | 12 April 2022 | CN | 116057394 | A | 02 May 2023 |
| | | | | EP | 4191262 | A1 | 07 June 2023 |
| | | | | JP | 2023-536496 | A | 25 August 2023 |
| | | | | US | 2023-0305065 | A1 | 28 September 2023 |
| | | | | WO | 2022-075708 | A1 | 14 April 2022 |
| KR | 10-2021-0066609 | A | 07 June 2021 | CN | 113994224 | A | 28 January 2022 |
| | | | | EP | 3961234 | A1 | 02 March 2022 |
| | | | | EP | 3961234 | A4 | 10 August 2022 |
| | | | | JP | 2022-535766 | A | 10 August 2022 |
| | | | | JP | 7403775 | B2 | 25 December 2023 |
| | | | | US | 11815558 | B2 | 14 November 2023 |
| | | | | US | 2022-0317196 | A1 | 06 October 2022 |
| | | | | WO | 2021-107323 | A1 | 03 June 2021 |
| US | 2019-0033376 | A1 | 31 January 2019 | KR | 10-2019-0011957 | A | 08 February 2019 |
| | | | | KR | 10-2439932 | B1 | 05 September 2022 |
| | | | | US | 10753980 | B2 | 25 August 2020 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230043045